# EUROPEAN PATENT SPECIFICATION

(11) **EP 1 610 287 B1**
(45) Date of publication and mention of the grant of the patent: **22.02.2012**
(21) Application number: 04722437.3
(22) Date of filing: 22.03.2004
(51) Int. Cl.: G09F 27/00, G06Q 30/00

(54) **ADVERTISEMENT INFORMATION PROVIDING SYSTEM USING TRANSPARENT ORGANIC EL DISPLAY, ADVERTISEMENT INFORMATION PROVIDING METHOD USING THE SYSTEM**
WERBUNGSINFORMATIONSBEREITSTELLUNGSSYSTEM MIT EINER TRANSPARENTEN ORGANISCHEN EL-ANZEIGE, WERBUNGSINFORMATIONSBEREITSTELLUNGSVERFAHREN MIT DEM SYSTEM
SYSTEME FOURNISSEUR D'INFORMATIONS PUBLICITAIRES UTILISANT UN AFFICHAGE EL ORGANIQUE TRANSPARENT, PROCEDE DE FOURNITURE D'INFORMATIONS PUBLICITAIRES AU MOYEN DUDIT SYSTEME

(30) Priority: 20.03.2003 JP 2003077189
(43) Date of publication of application: 28.12.2005
(73) Proprietor: Ojima, Ryotaro, Naka-ku, Yokohama-shi, Kanagawa 231-0868 (JP)
(72) Inventor: Ojima, Ryotaro, Naka-ku, Yokohama-shi, Kanagawa 231-0868 (JP)
(74) Representative: Beck, Michael Rudolf
(86) International application number: PCT/JP2004/003863
(87) International publication number: WO 2004/084161

(56) References cited:
- JP-A- 9 091 358
- JP-A- 58 086 829
- JP-A- 2001 249 927
- JP-A- 2002 006 769
- JP-A- 2002 072 963
- JP-A- 2002 094 085
- JP-A- 2002 209 201
- JP-A- 2002 259 809

## Description

### Background of the invention

This invention relates to the technology for realizing advertisement information providing system using transparent organic EL display. Conventionally there are various advertising methods. As such inventions, JPS58-86829, JPH9-91358, JP2001-13898, JP2001-202455, JP2001-283084, JP2002-6769, JP2002-72963, JP2002-94085, JP2002-215076, JP2002-216021, JP2002-229472, JP2002-251158, JP2002-259809, JP2002-328638, JP2002-351374, JP2003-43963, JP2003-108858, JP2003-122266, JP2003-223144, JP2003-255878, JP2003-308025, JP2003-323444 are known.

US 2002/122059 A1 discloses an advertisement information server which is connected via a network with a plurality of user terminals. Each user terminal acquires the outputted distribution information from the network and outputs the advertisement information contained in the acquired distribution information. This prior art system works like internet when watching a video sequence. It is not suitable for real time advertisement because all advertisement information is transmitted from the server to the user terminal.

### Summary of the invention

Advertisement information was not in real time and was fixed, and there was a problem of not being suitable in a local advertisement peculiar to an area.

In this invention, in order to conquer the above-mentioned subject, it aims at offer of an advertisement information providing system using transparent organic EL display, an advertisement information providing method using this display and a recording medium.

Accordingly, the present invention provides an advertisement information providing system comprising the features of claim 1. An advantageous embodiment is claimed in claim 2.

This invention is a new advertisement method and advertisement information will become real time, it comes to be easy of a local advertisement peculiar to an area, and it contributes to development of local promotion and a specific local industry.

### Brief Description of the Drawings

- Fig. 1: is a block diagram showing the composition of an advertisement information providing system.
- Fig. 2: is a flow chart which shows operation of the advertisement information providing system.
- Fig. 3: is a figure showing an entrance or a show window.

### Description of the Preferred Embodiments

Hereafter, the form of implementation of this invention is explained with reference to a drawing.

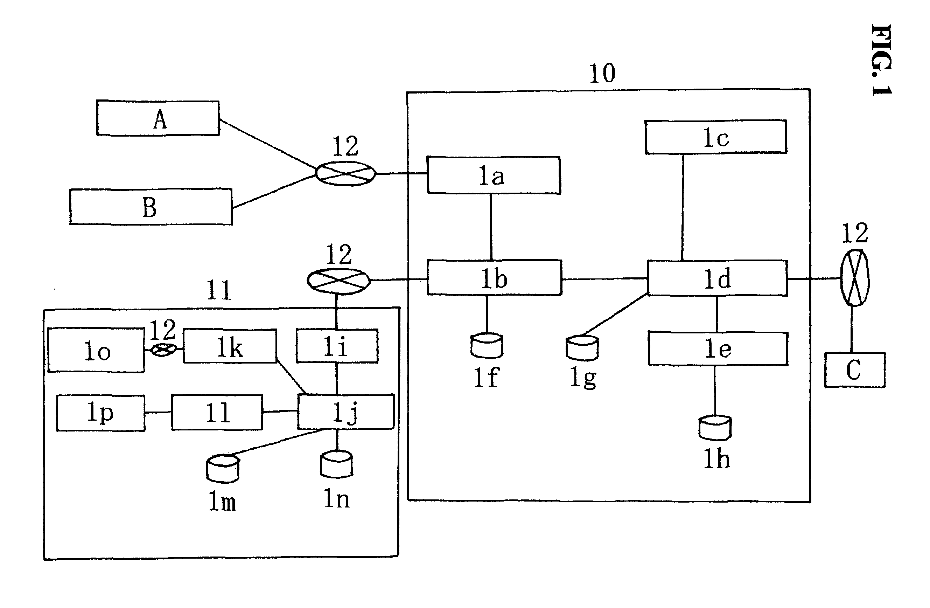

Fig. 1 is a block diagram showing the composition of an advertisement information providing system Each block except a database specifically consists of peripheral LSI containing CPU and a memory and CPU reads out the program containing the operating system recorded on the memory and performs it one by one. And each function is performed.

As shown in this figure, an advertisement information providing system is equipped with advertisement information providing server 10 and advertisement information providing unit 11 and communicate network 12. Advertisement information providing server 10 is constituted by line control section 1a, communication information management section 1b, position information management section 1c, advertisement information management section 1d, program designing section 1e, access log database 1f, advertisement information database 1g, program database 1h. The place of advertisement information providing server 10 is not asked.

Advertisement information consists of image data and audio data.

Line control section 1a receives the data wishing advertisement information provide from advertisement information providing terminal and receives the signal wishing advertisement information distribution from consumer's terminal and distributes the advertisement information on hope. The data wishing advertisement information provide is the data including the conditions of wish at the time of providing advertisement information and this is a sex or an age group or a time zone of choice or a day of the week, etc. of the consumer for advertisement information. Moreover, the signal wishing advertisement information distribution is a signal which indicates its intention of the purport which wishes distribution of advertisement information.

Consumer's terminal is constituted by the communication terminal represented by a portable telephone, PHS, PDA, PC, etc. In addition, advertisement information provider's terminal, advertisement information providing unit 11 and consumer's terminal are the separate composition of having become independent, respectively.

Communication information management section 1b transmits advertisement information to advertising information providing unit 11.

Position information management section 1c has a function of GPS or a part of functions of PHS or a portable telephone.

Advertisement information management section 1d receives the information which includes advertisement information from information source and transmits to advertisement information database 1g and saves. Moreover, position information is acquired from position information management section 1c.

Moreover, advertisement information management section 1d memorizes the access log including a notice place from consumer's terminal to access log database 1f through line control section 1a and communication information management section 1b.

Program designing section 1e designs a time program based on the data wishing advertisement information provide received from advertisement information provider's terminal. The designed time program is transmitted from program designing section 1e to program database 1h and memorized.

Although there are various methods as information source and communicate network 12, they do not limit especially.

Advertisement information providing unit 11 is constituted by communication section 1i, advertisement information control section 1j, display control section 1k, audio output section 1l, program database 1m, advertisement information database 1n, transparent organic EL display 1o and speaker 1p. Transparent organic EL display 1o may serve as speaker 1p. Advertisement information provider's unit 11 is put on a store, vehicles, etc. Transparent organic EL display is a technology which is already known.

Advertisement information control section 1j transmits advertisement information to advertisement information database In and a time program to program database 1m and memorizes. Moreover, advertisement information control section 1j outputs the advertisement information according to the time program.

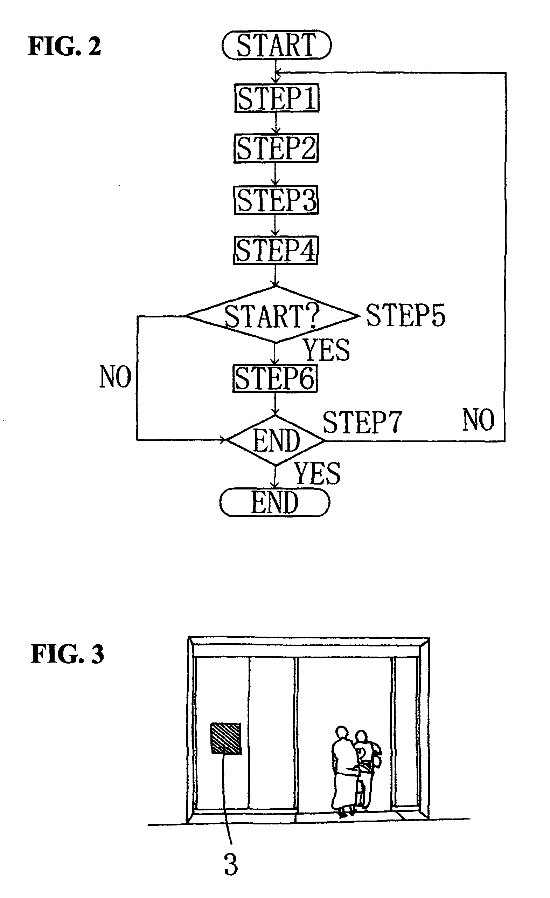

Next, operation of an advertisement information providing system is explained with reference to Fig. 2. Fig. 2 is a flow chart which shows operation of advertisement information providing system.

As shown in Fig. 2, the data wishing advertisement information provide transmitted from advertisement information provider's terminal through communicate network 12 is firstly received in line control section 1a of the advertisement information providing server 10 (Step 1).

Based on this, advertisement information management section 1d chooses advertisement information based on the data wishing advertisement information provide or the position information from position information management section 1c and receives. Moreover, it transmits the above-mentioned advertisement information to advertisement information database 1g and makes it memorized (Step 2).

On the other hand in program designing section 1e, the time program of the advertisement information to provide is designed based on the data wishing advertisement information provide. The designed time program is transmitted to program database 1h from program designing section 1 e and is memorized.

Then, if it becomes the time when advertisement information is transmitted to advertisement information providing unit 11 from advertisement information providing server 10, advertisement information will be read out from advertisement information database 1g and transmitted to advertisement information providing unit 11 through advertisement information management section 1d, communication information management section 1b, and communicate network 12. The time program memorized by program database 1h is also transmitted with this transmission of advertisement information (Step 3).

In communication section 1i of advertisement information providing unit 11, received advertisement information is transmitted to advertisement information database In through advertisement information control section 1j and memorized. With this advertisement information, the transmitted time program is transmitted to program database 1m and also memorized.

In advertisement information control section 1j, according to the time program which is received, advertisement information is read out from advertisement information database In and transmitted to display control section 1k and audio output section 1l. In transparent organic EL display 1o and speaker 1p, the received advertisement information is outputted respectively (Step 4).

On the other hand, it is an end if the signal wishing advertisement information distribution from consumer's terminal is not received in line control section 1a. But when it is received, advertisement information management section 1d transmits the access log which is sent from a consumer to access log database 1f through line control section 1a and communication information management section 1b and makes it memorized.

In advertisement information management section 1d, if it is checked that the above-mentioned signal wishing advertisement information distribution is received in line control section 1a (Step 5),
advertisement information will be read out from advertisement information database 1g and distributed to consumer's terminal from advertisement information management section 1d through communication information management section 1b and line control section 1a (Step 6). And the received advertisement information is outputted in consumer's terminal.

And the above operation is repeated until operation of an end is performed in consumer's terminal or advertisement information providing server 10 or advertisement information providing unit 11 (Step 7).

Moreover, when used for a traffic advertisement, for example, the above-mentioned advertisement information providing unit 11 or the both of advertisement information providing server 10 and advertisement information providing unit 11 are established in an omnibus transportation vehicle and a management center (un-illustrating) is prepared.

Fig. 3 is a figure showing an entrance or a show window. 3 is the case where transparent organic EL display sticks on the door of an entrance or a show window.

Each part may be realized by the hardware of exclusive use and composed of the memory and CPU and that function may be performed by loading a program for realizing the function of each part to a memory.

Above mentioned is one example of this invention and it is used for out of home media or traffic advertisement such as advertisement on the cars or trains. It is needless to say that this invention is not limited to the composition of this enforcement form.

### List of reference numbers

- 10: advertisement information providing server
- 11: advertisement information providing unit
- 12: communicate network
- 1 a: line control section
- 1b: communication information management section
- 1c: position information management section
- 1d: advertisement information management section
- 1e: program designing section
- 1f: access log database
- 1g: advertisement information database
- 1h: program database
- 1i: communication section
- 1j: advertisement information control section
- 1k: display control section
- 1l: audio output section
- 1 m: program database
- 1n: advertisement information database
- 1o: transparent organic EL display
- 1p: speaker
- A: consumer's terminal
- B: advertisement information providing terminal
- C: information source

## Claims

1. An advertisement information providing system using a transparent organic EL display, including:
- an advertisement information providing server (10) comprising
- an advertisement information management section (1d) for receiving transmitted advertisement information from an advertisement information provider terminal (B) ,
- an advertisement information database (1g) for storing the advertisement information received by the advertisement information management section (1d),
- a communication information management section (1b) for transmitting said advertisement information to an advertisement information providing unit (11), and
- a line control section (1a) for receiving a data wishing advertisement information provide, which is data including the conditions of a wish for advertisement information at the time of providing advertisement information from said advertisement information provider terminal (B) and the signal wishing advertisement information distribution from a consumer's terminal (A), and
- the advertisement information providing unit (11) comprising
- a communication section (1i) for receiving the advertisement information sent from the advertisement information providing server (10),
- an advertisement information control section (1j) for storing advertisement information data sent from the communication section (1i) into an advertisement information database (In) and reading out advertisement information according to a time program of a program database (1m), and
- a transparent organic EL display (1o) and speakers for outputting the read out advertisement information through a display control section (1k) and audio output section.

2. An advertisement information providing method using a system according to claim 1, comprising the steps of :
- receiving advertisement information transmitted through communication network (12) in an advertisement information providing server (10),
- transmitting the advertisement information to an advertisement information providing unit (11) through the communication network (12) and
- distributing the advertisement information to a consumer's terminal, and
- wherein in said advertisement information providing unit (11) the advertisement information sent from said advertisement information providing server (10) is received and output on a transparent organic EL display (1o) and speakers.

## Patentansprüche

1. Werbungsinformationsbereitstellungssystem mit einer transparenten organischen EL-Anzeige, das Folgendes aufweist:
- einen Werbungsinformationsbereitstellungsserver (10), der umfasst:
- einen Werbungsinformationsverwaltungsabschnitt (1d) zum Empfangen gesendeter Werbungsinformationen von einer Werbungsinformationsbereitstellungsendstelle (B),
- eine Werbungsinformationsdatenbank (1g) zum Speichern der vom Werbungsinformationsverwaltungsabschnitt (1d) empfangenen Werbungsinformationen,
- einen Kommunikationsinformationsverwaltungsabschnitt (1b) zum Senden der Werbungsinformationen an eine Werbungsinformationsbereitstellungseinheit (11), und
- einen Leitungssteuerungsabschnitt (1a) zum Empfangen von Daten mit dem Wunsch nach einer Werbungsinformationsbereitstellung, wobei es sich um Daten handelt, welche die Bedingungen eines Wunsches nach Werbungsinformationen zum Zeitpunkt der Bereitstellung von Werbungsinformationen von der Werbungsinformationsbereitstellungsendstelle (B) sowie das Signal mit dem Wunsch nach Werbungsinformationsverteilung von dem Endgerät (A) eines Verbrauchers aufweisen, und
- die Werbungsinformationsbereitstellungseinheit (11), die Folgendes umfasst:
- einen Kommunikationsabschnitt (1i) zum Empfangen der vom Werbungsinformationsbereitstellungsserver (10) gesendeten Werbungsinformationen,
- einen Werbungsinformationssteuerungsabschnitt (1j) zum Speichern von Werbungsinformationsdaten, die von dem Kommunikationsabschnitt (1i) gesendet werden, in einer Werbungsinformationsdatenbank (1n) und zum Auslesen der Werbungsinformationen gemäß einem Zeitprogramm einer Datenbank (1m), und
- ein transparentes organisches EL-Display (1o) und Lautsprecher zum Ausgeben der ausgelesenen Werbungsinformationen durch einen Anzeigensteuerungsabschnitt (1k) und einen Audio-Ausgabeabschnitt.

2. Ein Werbungsinformationsbereitstellungsverfahren mit einem System nach Anspruch 1, das folgende Schritte umfasst:
- Empfangen von über ein Kommunikationsnetzwerk (12) gesendeten Werbungsinformationen in einem Werbungsinformationsbereitstellungserver (10),
- Senden der Werbungsinformationen an eine Werbungsinformationsbereitstellungseinheit (11) über das Kommunikationsnetzwerk (12) und
- Verteilen der Werbungsinformationen an das Endgerät eines Verbrauchers, und
- wobei in einer Werbungsinformationsbereitstellungseinheit (11) die von dem Werbungsinformationsbereitstellungsserver (10) gesendeten Werbungsinformationen empfangen und an einem transparenten organischen EL-Display (1o) und Lautsprechern ausgegeben werden.

## Revendications

1. Système de fourniture d'informations de publicité utilisant un affichage électroluminescent organique transparent comprenant :
- un serveur de fourniture d'informations de publicité (10) comprenant :
- une section de gestion d'informations de publicité (1d) pour recevoir des informations de publicité transmises par un terminal fournisseur d'informations de publicité (B),
- une base de données d'informations de publicité (1g) pour stocker les informations de publicité reçues par la section de gestion d'informations de publicité (1d),
- une section de gestion d'informations de communication (1b) pour transmettre lesdites informations de publicité à une unité de fourniture d'informations de publicité (11) et
- une section de contrôle en ligne (1a) pour recevoir des informations de publicité de souhait de données qui sont des données comprenant les conditions d'un souhait d'informations de publicité au moment de la fourniture des informations de publicité par ledit terminal de fourniture d'informations de publicité (B) et le signal de souhait de distribution des informations de publicité par le terminal d'un consommateur (A) et
- l'unité de fourniture d'informations de publicité (11) comprenant
- une section de communication (li) pour recevoir les informations de publicité envoyées par le serveur de fourniture d'informations de publicité (10),
- une section de contrôle des informations de publicité (1j) pour stocker des données d'information de publicité envoyées par la section de communication (li) dans une base de données de publicité (1n) et extraire des informations de publicité selon un programme temps d'une base de données de programme (lm) et
- un affichage électroluminescent organique transparent (1o) et des haut-parleurs pour extraire les informations de publicité extraites par une section de contrôle d'affichage (lk) et une section de sortie audio.

2. Procédé de fourniture d'informations de publicité utilisant un système selon la revendication 1 comprenant les étapes de :
- réception des informations de publicité transmises par un réseau de communication (12) dans un serveur de fourniture d'informations de publicité (10),
- transmission des informations de publicité à une unité de fourniture d'informations de publicité (11) par le réseau de communication (12) et
- distribution des informations de publicité au terminal d'un consommateur et
- dans lequel les informations de publicité envoyées par ledit serveur de fourniture d'informations de publicité (10) sont reçues dans ladite unité de fourniture d'informations de publicité (11) et sont extraites sur un affichage électroluminescent organique transparent (1o) et des haut-parleurs.
